# EUROPEAN PATENT SPECIFICATION

(11) **EP 2 573 805 B1**
(45) Date of publication and mention of the grant of the patent: **30.11.2016**
(21) Application number: 12177541.5
(22) Date of filing: 23.07.2012
(51) Int. Cl.: H01L 21/56, H01L 23/29

(54) **Aerogel dielectric layer**
Dielektrische Aerogel-Schicht
Couche diélectrique d'aérogel

(30) Priority: 23.09.2011 US 201113200477
(43) Date of publication of application: 27.03.2013
(73) Proprietor: RAYTHEON COMPANY, Waltham MA 02451-1449 (US)
(72) Inventor: Hauhe, Mark S., Hermosa Beach, CA 90254 (US); Cisco, Terry C., Glendale, CA 91206 (US); Milne, Jason G., Hawthorne, CA 90250-6550 (US); Gould, George, Mendon, MA 01756 (US); Nahass, Paul, Glastonbury, CT 06022 (US); Zafiropoulous, Nick, Wayland, MA 01778 (US)
(74) Representative: Carpmaels & Ransford LLP

(56) References cited:
- JP-A- 2000 154 273
- US-A1- 2005 006 766
- US-A1- 2010 110 651
- US-A1- 2011 074 012
- US-A1- 2011 226 041
- US-B1- 6 656 527
- GOTTFRIED K ET AL: "Cu/barrier CMP on porous low-k based interconnect schemes", MICROELECTRONIC ENGINEERING, ELSEVIER PUBLISHERS BV., AMSTERDAM, NL, vol. 83, no. 11-12, 1 November 2006 (2006-11-01), pages 2218-2224, XP024954769, ISSN: 0167-9317, DOI: 10.1016/J.MEE.2006.10.007 [retrieved on 2006-11-01]

## Description

### FIELD

The present invention relates generally to aerogel dielectric layers, and more specifically, to aerogel dielectric layers on integrated circuit chips.

### BACKGROUND OF THE INVENTION

Monolithic microwave integrated circuit ("MMIC") chips are often mounted on a circuit board by metal or solder posts to form a MMIC chip system. When a MMIC chip is mounted with the circuits facing the circuit board, it is referred to as a "MMIC flip chip system." The difference in thermal expansion properties between the MMIC flip chip and the circuit board can create mechanical stresses on the metal or solder posts when the system experiences temperature cycles or large thermal fluctuations. These stresses may render the system unreliable.

A conventional solution is to insert an underfill material having desirable mechanical properties between the MMIC flip chip and the circuit board to reduce the stresses on the metal or solder posts. However, due to undesirable dielectric properties, underfill contacting sensitive components of the MMIC flip chip can degrade the electrical performance of the chip.

Prior solutions to this problem include using tall metal or solder posts that provide sufficient flexibility during thermal expansion to alleviate the need for underfill. Another approach is to apply underfill carefully to avoid the sensitive components of the MMIC flip chip. Both of these approaches require non-standard processes and are therefore unavailable or expensive to implement.

US2011074012 describes a substrate with a built-in semiconductor element, and a method of fabricating a substrate with a built-in semiconductor element, that suppresses effects of a dielectric on a semiconductor element that is structured to include a distributed constant circuit, and that can protect the semiconductor element from load applied thereto at the time of fabrication.

US2005006766 describes a semiconductor device that includes a semiconductor substrate, a first wiring arranged on the semiconductor substrate, a first electrode pad electrically connected to the first wiring, and a porous organic resin film covering the front surface of the semiconductor substrate such that the first electrode pad is exposed to the outside.

### SUMMARY

The present invention is defined by the independent claims with further details of specific embodiments provided by the dependent claims.

In one embodiment, the aerogel has a dielectric constant of approximately 2.0 or less and a compression strength of at least approximately 100 psi (0,689476 MPa). In another embodiment, the aerogel has a dielectric constant of approximately 1.5 or less and a compression strength of at least approximately 100 psi (0,689476 MPa). In another embodiment, the aerogel has a density of approximately 0.05 g/cc (0,05 g/cm³) to 0.30 g/cc (0,30 g/cm³), and a compression strength of approximately 100 psi (0,689476 MPa) to 400 psi (2,758 MPa). In yet another embodiment, the aerogel has a dielectric constant of approximately 1.15 to 1.40, a density of approximately 0.10 g/cc (0,10 g/cm³) to 0.25 g/cc (0,25 g/cm³), and a compression strength of approximately 100 psi (0,689476 MPa) to 360 psi (2,482 MPa).

The aerogel may have a loss tangent of approximately 0.002 to 0.007, and the aerogel dielectric layer may be approximately 5 µm to 20 µm thick.

The MMIC flip chip may be fixed to the circuit board by one or more solder bumps or solder posts.

In a further refinement of the circuit board, the aerogel has a dielectric constant of approximately 2.0 or less.

In a further refinement of the circuit board, the aerogel has a dielectric constant of approximately 1.5 or less.

In a further refinement of the circuit board, the aerogel has a compression strength of at least approximately 100 psi (0,689476 MPa).

In a further refinement of the circuit board, the aerogel has a compression strength of approximately 100 psi (0,689476 MPa) to 400 psi (2,758 MPa).

In a further refinement of the circuit board, the aerogel has a density of approximately 0.05 g/cc (0,05 g/cm³) to 0.30 g/cc (0,30 g/cm³).

In a further refinement of the circuit board, the circuit is a monolithic microwave integrated circuit and the aerogel is disposed over a portion of the monolithic microwave integrated circuit comprising at least a field-effect transistor.

In a further refinement of the circuit board, an underfill is applied between the circuit and the circuit board, and wherein the aerogel is disposed between the underfill and a portion of the circuit.

In a further refinement of the circuit board, the aerogel has a dielectric constant of approximately 1.15 to 1.40, a density of approximately 0.10 g/cc (0,10 g/cm³) to 0.25 g/cc (0,25 g/cm³), and a compression strength of approximately 100 psi (0,689476 MPa) to 360 psi (2,482 MPa).

In a further refinement of the circuit board, the aerogel has a loss tangent of approximately 0.002 to 0.007.

In a further refinement of the circuit board, the thickness of the dielectric layer is approximately 5 µm to 20 µm.

In a further refinement of the circuit board, the monolithic microwave integrated circuit is fixed to the circuit board by one or more solder bumps or solder posts, wherein an underfill is applied between the monolithic microwave integrated circuit and the circuit board, and wherein the aerogel is disposed between the underfill and the portion of the monolithic microwave integrated circuit comprising at least the field effect transistor.

In a further embodiment, the invention relates to a method for preparing a dielectric layer for a circuit on a chip facing a circuit board and spaced apart from the circuit board, the method comprising: applying an aerogel between the circuit and the circuit board.

In a refinement of the method, the aerogel is applied by: depositing a gelling precursor solution on a portion of the circuit; processing the gelling precursor solution to form the dielectric layer comprising the aerogel on the portion of the circuit; and mounting the circuit to the circuit board such that the aerogel is between the circuit and the circuit board.

In a refinement of the method, the method further comprising applying an underfill between the circuit and the circuit board, wherein the aerogel is disposed between the portion of the circuit and the underfill.

In a refinement of the method, the aerogel has a dielectric constant of approximately 2.0 or less and a compression strength of at least approximately 100 psi.

In a refinement of the method, the aerogel has a dielectric constant of approximately 1.5 or less, a density of approximately 0.05 g/cc (0,05 g/cm³) to 0.30 g/cc (0,30 g/cm³), and a compression strength of approximately 100 psi (0,689476 MPa) to 400 psi (2,758 MPa).

In a refinement of the method, the aerogel has a dielectric constant of approximately 1.15 to 1.40, a density of approximately 0.10 g/cc (0,10 g/cm³) to 0.25 g/cc (0,25 g/cm³), and a compression strength of approximately 100 psi (0,689476 MPa) to 360 psi (2,482 MPa).

In a refinement of the method, the gelling precursor solution is deposited by spin coating, stencil printing or dot dispensing.

In a refinement of the method, the gelling precursor solution is deposited by dot dispensing.

In a refinement of the method, the gelling precursor solution is applied to a portion of the circuit comprising a field effect transistor.

In a refinement of the method, the aerogel has a loss tangent of approximately 0.002 to 0.007.

### BRIEF DESCRIPTION OF THE DRAWINGS

FIG. 1A is a schematic plan view of a monolithic microwave integrated circuit ("MMIC") flip chip having an aerogel dielectric layer over selected areas in accordance with one embodiment of the invention.
FIG. 1B is a schematic partially cross-sectional diagram of the MMIC flip chip shown in FIG. 1 a positioned over a circuit board.
FIG. 1C is a schematic partially cross-sectional diagram of the MMIC flip chip and circuit board shown in FIG. 1b mounted by solder posts.
FIG. 1D is a schematic partially cross-sectional diagram of the MMIC flip chip and circuit board shown in FIG. 1c with underfill disposed between the MMIC flip chip and the circuit board.
FIG. 2 is a cross-sectional view of a MMIC flip chip mounted on a circuit board showing an aerogel dielectric layer over selected areas of the MMIC flip chip and an underfill between the MMIC flip chip and the circuit board.
FIG. 3 is a flow chart showing a method for preparing a MMIC flip chip system having an aerogel dielectric layer in accordance with one embodiment of the invention.
FIGS. 4A and 4B are graphs comparing the performance of MMIC chips without and with an aerogel dielectric layer.
FIG. 5 is a graph showing the relationship between density and dielectric constant for three types of aerogels.
FIG. 6 is a graph showing the relationship between density and compression strength for three types of aerogels.
FIG. 7 is a graph showing the relationship between density and loss tangent for three types of aerogels.

### DETAILED DESCRIPTION

Referring now to the drawings, embodiments of an aerogel dielectric layer are incorporated into a MMIC flip chip system including a MMIC flip chip mounted to a circuit board. The circuit board may include any of a variety of known board types, including without limitation, printed circuit boards, printed wiring boards, hybrid boards, and the like. For convenience, the term "circuit board" will be used to refer to any of those types of boards with which the invention is used. In the invention, the aerogel dielectric layer is disposed between sensitive components of the MMIC flip chip, for example a field-effect transistor ("FET"), and the circuit board. In MMIC flip chip systems including an underfill between the MMIC flip chip and the circuit board, the aerogel dielectric layer is displayed between sensitive components of the MMIC flip chip and the underfill.

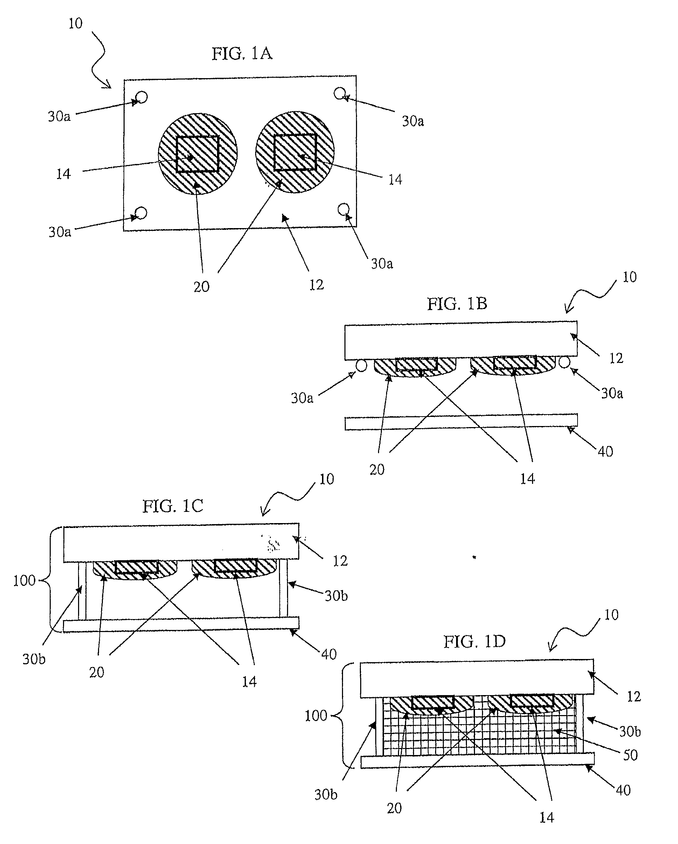

As shown in FIG. 1A, the MMIC flip chip 10 includes a chip 12 containing at least one FET 14 and a plurality of solder bumps 30a. An aerogel dielectric layer 20 covers portions of the surface of the MMIC flip chip 10, including the FET 14 and any other sensitive components (not shown).

FIG. 1B shows the components of the MMIC flip chip 10 including the FET 14 and the plurality of solder bumps 30a face the circuit board 40. The aerogel dielectric layer 20 covers the FET 14 at a location between the FET 14 and the circuit board 40.

FIG. 1C shows the MMIC flip chip 10 mounted to the circuit board 40 to form a MMIC flip chip system 100. The plurality of solder bumps 30a are heated or otherwise liquefied to form a plurality of solder posts 30b that connect the chip 12 to the circuit board 40. The plurality of solder posts 30b are sized such that the aerogel dielectric layer 20 and any other components (not shown) of the MMIC flip chip 10 are spaced apart from the circuit board 40. In one embodiment, the gap between the MMIC chip and the circuit board is approximately 100 to 150 µm.

As shown in FIG. 1D, the MMIC flip chip system 100 further includes an underfill 50 between the MMIC flip chip 10 and the circuit board 40. The aerogel dielectric layer 20 prevents the underfill 50 from contacting the FET 14 and other sensitive components (not shown).

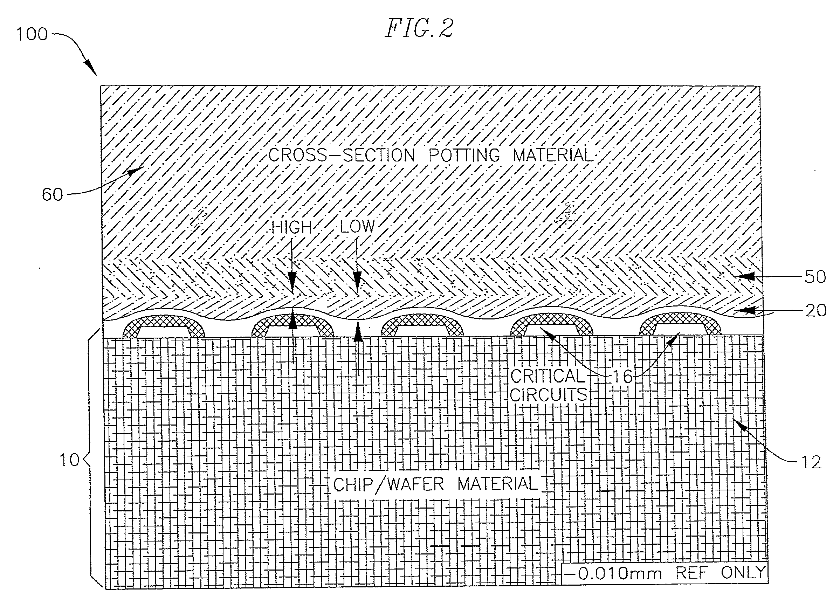

FIG. 2 illustrates a MMIC flip chip system 100 including a MMIC flip chip 10 having a chip 12 supporting a plurality of critical circuits 16. The aerogel dielectric layer covers the plurality of critical circuits 16 and prevents the underfill 50 from contacting the plurality of critical circuits 16. The MMIC flip chip system 100 further includes a potting material 60 to reduce shock and vibration and to exclude moisture and corrosive materials.

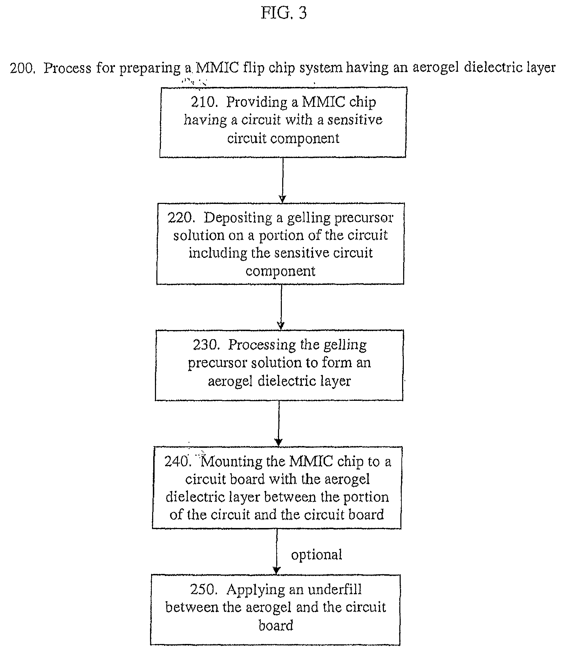

FIG. 3 is a flow chart showing a process 100 for preparing a MMIC flip chip system having an aerogel dielectric layer in accordance with one embodiment of the invention. In particular, the process 200 can be used to prepare a MMIC flip chip system 100 as shown in FIGS. 1A-1D. The process 200 includes providing 210 a MMIC chip having at least one circuit. The process further includes depositing 220 a gelling precursor solution on a portion of the circuit including a sensitive component, for example a FET. The gelling precursor solution may be deposited by any suitable process such as, for example, spin coating, stencil printing or dot dispensing. In one embodiment, the gelling precursor solution is deposited by dot dispensing. The gelling precursor solution is then processed 230 on the portion of the circuit including a sensitive component to form an aerogel dielectric layer on that portion of the circuit. The processing may include drying by any suitable process, for example, supercritical CO₂ drying at 55°C and 1600 psi. The process includes mounting 240 the MMIC chip to a circuit board such that the aerogel dielectric layer is positioned between the circuit and the circuit board. The mounting may include providing solder bumps or solder posts to attach the MMIC chip to the circuit board. The process optionally includes applying 250 an underfill between the MMIC chip and the circuit board, wherein the aerogel dielectric layer is positioned between the portion of the circuit and the underfill. The underfill fills the gap between the MMIC chip and the circuit board through capillary action, and is then hardened. In one embodiment, the underfill is an epoxy that is hardened by curing.

Adhesion of the underfill to the MMIC chip relies partially on contact between the underfill and the MMIC chip itself. Therefore, in many embodiments, the aerogel dielectric layer does not cover the entire MMIC chip. However, materials having a high dielectric constant, such as underfill, placed adjacent sensitive components of the MMIC chip, such as a FET, tend to degrade performance of the MMIC chip by interfering with electric fields created during its operation. An aerogel having a low dielectric constant reduces the extent of any interference with these electric fields, and therefore reduces any adverse impact on the MMIC chip performance. Performance degradation due to close proximity to a high dielectric constant underfill can be reduced by providing an aerogel dielectric layer having a dielectric constant of approximately 2.0 or less and a thickness of approximately 5 µm to 20 µm disposed between at least those portions of the MMIC chip having sensitive components and the underfill. In one embodiment, the aerogel dielectric layer has a dielectric constant of approximately 1.5 or less.

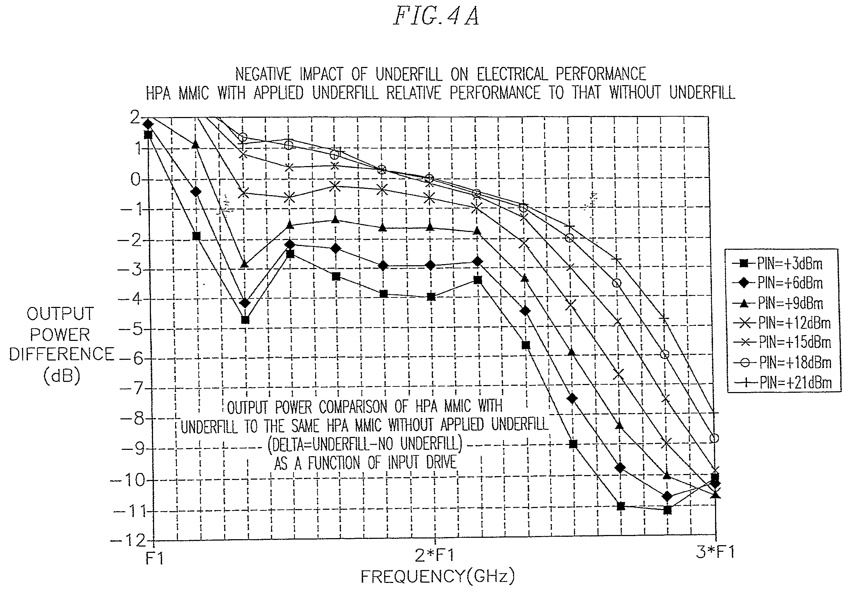

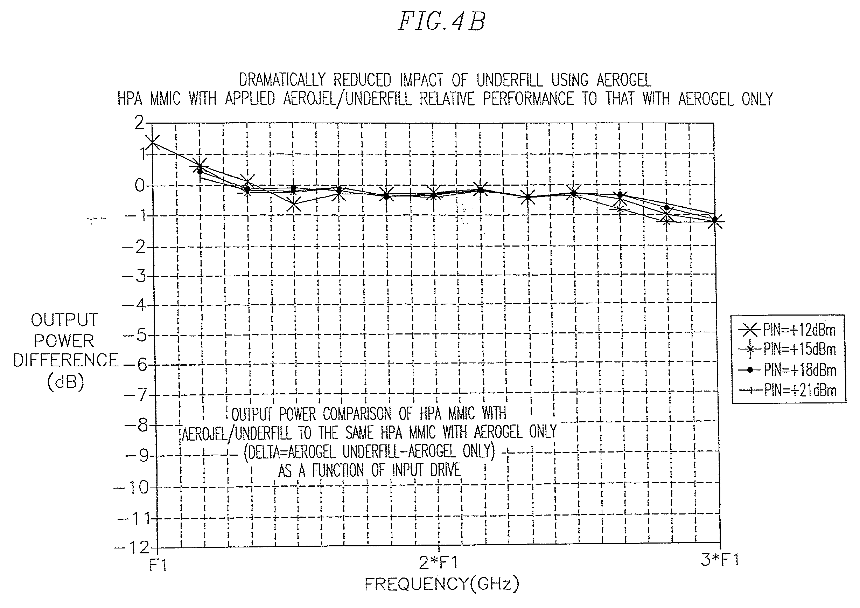

FIG. 4A shows the output power difference between seven chips having an underfill and the same chips without an underfill. As shown, the output power is significantly compromised when underfill is applied. FIG. 4B shows the output power difference between four chips having an aerogel, for example as shown in FIG. 1C, and the same chips having an aerogel and underfill, for example as shown in FIG. 1D. As shown, the output power difference with and without underfill is small when aerogel is present. The impact of underfill is therefore reduced with an aerogel layer between the chip and the underfill.

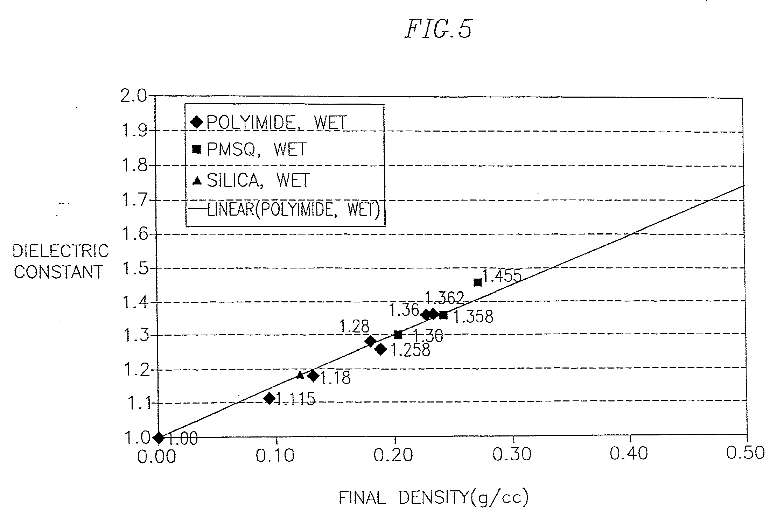

In one embodiment, the aerogel of the aerogel dielectric layer has a density of approximately 0.05 g/cc (0,05 g/cm³) to 0.30 g/cc (0,30 g/cm³). FIG. 5 is a graph showing the relationship between density and dielectric constant for three types of aerogels. Polyimide, PMSQ and silica aerogel samples having densities of approximately 0.05 g/cc (0,05 g/cm³) to 0.30 g/cc (0,30 g/cm³) all had dielectric constants below 1.5.

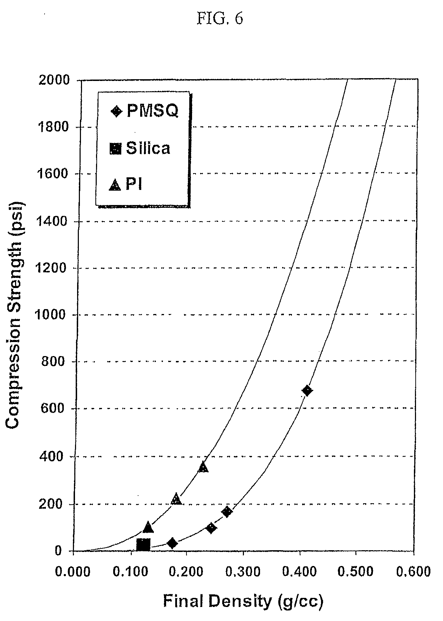

The aerogel must be strong enough to support itself in place during the processes leading up to the underfill application. The aerogel must also be strong enough to resist the flow of underfill during the underfill application so that the aerogel remains in place over the sensitive components of the MMIC chip. In one embodiment, the aerogel of the aerogel dielectric layer has a compression strength of at least approximately 100 psi (0,689476 MPa). In another embodiment, the compression strength of the aerogel is approximately 100 psi (0,689476 MPa) to 400 psi (2,758 MPa). FIG. 6 shows the relationship between density and compression strength for three types of aerogels. Polyimide (PI) shows the highest compression strength for a given density compared with silica and PMSQ.

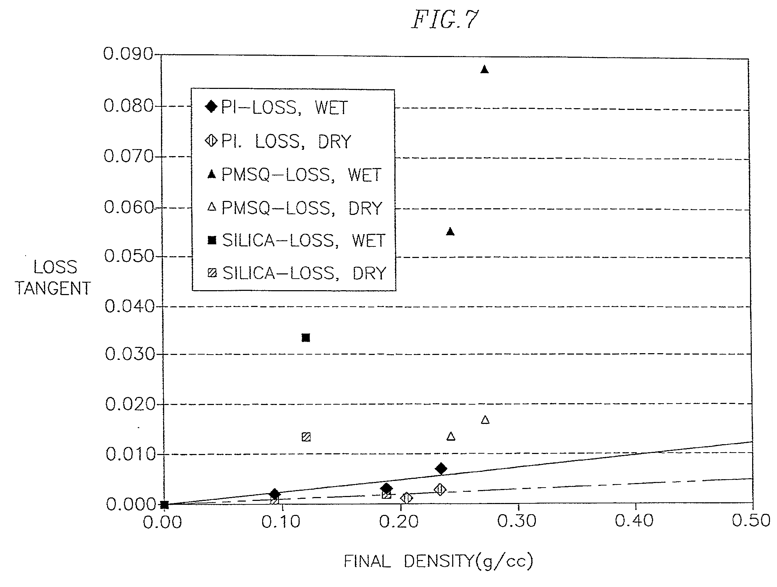

The aerogel dielectric layer may have a loss tangent of approximately 0.002 to 0.007. A low loss tangent is desirable because it reduces the rate at which electromagnetic energy is dissipated. FIG. 7 is a graph showing the relationship between density and loss tangent for three types of aerogels. Polyimide (PI) exhibits a lower loss tangent than either PMSQ or silica over the desired range of densities.

Table 1 shows properties for three samples of polyimide aerogels. These three samples exhibit a dielectric constant of approximately 1.15 to 1.40, a density of approximately 0.10 g/cc (0,10 g/cm³) to 0.25 g/cc (0,25 g/cm³) and a compression strength of approximately 100 psi (0,689476 MPa) to 360 psi (2,482 MPa).

**Table 1.**

| | **Dielectric Constant** | **Density (g/cc) (g/cm³)** | **Compression Strength (psi) [MPa]** |
|---|---|---|---|
| **PI-3** | 1.18 | 0.131 | (101.6) [0,70051] |
| **PI-4** | 1.36 | 0.227 | (356.8) [2,46] |
| **PI-5** | 1.28 | 0.180 | (220.7) [1,5217] |

While the above description contains many specific embodiments of the invention, these should not be construed as limitations on the scope of the invention, but rather as examples of specific embodiments thereof. Accordingly, the scope of the invention should be determined not by the embodiments illustrated, but by the appended claims and their equivalents.

## Claims

1. A circuit board assembly (100) comprising:
a circuit board (40);
a monolithic microwave integrated circuit flip chip (12) attached to the circuit board (40), the flip chip (12) having a plurality of sensitive components (14) facing the circuit board (40) and wherein the flip chip is spaced from the circuit board in a flip chip configuration;
a plurality of dielectric layer (20) regions between the plurality of sensitive components (14) and the circuit board (40), wherein the dielectric layer regions (20) are separated and comprise an aerogel; and
an underfill (50) between the flip chip and the circuit board, the underfill being connected to the circuit board and the flip chip, wherein the dielectric layer regions prevent the underfill from contacting the sensitive components.

2. The circuit board assembly according to claim 1, wherein the aerogel has a dielectric constant of approximately 2.0 or less.

3. The circuit board assembly according to claim 1 or 2, wherein the aerogel has a dielectric constant of approximately 1.5 or less.

4. The circuit board assembly according to any of claims 1 to 3, wherein the aerogel has a compression strength of approximately 100 psi (0,689476 MPa) to 400 psi (2,758 MPa).

5. The circuit board assembly according to any of claims 1 to 4, wherein the aerogel has a density of approximately 0.05 g/cc (0,05 g/cm³) to 0.30 g/cc (0,30 g/cm³).

6. The circuit board assembly according to any of claims 1 to 5, wherein the aerogel is disposed over a portion of the flip chip (12) comprising at least a field-effect transistor (14).

7. The circuit board assembly according to any of claims 1 to 6, wherein the aerogel has a dielectric constant of approximately 1.15 to 1.40, a density of approximately 0.10 g/cc (0,10 g/cm³) to 0.25 g/cc (0,25 g/cm³), and a compression strength of approximately 100 psi (0,689476 MPa) to 360 psi (2,482 MPa).

8. The circuit board assembly according to any of claims 1 to 7, wherein the aerogel has a loss tangent of approximately 0.002 to 0.007.

9. A method (200) for preparing a plurality of dielectric layer regions for a plurality of sensitive components(14) on a monolithic microwave integrated circuit flip chip (12) facing a circuit board (40) and spaced apart from the circuit board (40) in a flip chip configuration, the method (200) comprising:
applying an aerogel over the plurality of sensitive components to respectively cover the plurality of sensitive components, wherein the dielectric layer regions are laterally separated and between the flip chip (12) and the circuit board (40); and
applying an underfill between the flip chip (12) and the circuit board (40), wherein the underfill (50) contacts the circuit board (40) and the flip chip (12).

10. The method according to claim 9, wherein the aerogel is applied by:
depositing (220) a gelling precursor solution on a portion of the flip chip (12) ;
processing (230) the gelling precursor solution to form the dielectric layer regions comprising the aerogel on the portion of the flip chip (12); and
mounting (240) the flip chip (12) to the circuit board (40) such that the aerogel is between the flip chip (12) and the circuit board (40).

11. The method according to any of claims 9 to 10, wherein the aerogel has a dielectric constant of approximately 2.0 or less and a compression strength of at least approximately 100 psi (0,689476 MPa).

12. The method according to any of claims 9 to 11, wherein the aerogel has a dielectric constant of approximately 1.5 or less, a density of approximately 0.05 g/cc (0,05 g/cm³) to 0.30 g/cc (0,30 g/cm³), and a compression strength of approximately 100 psi (0,689476 MPa) to 400 psi (2,758 MPa).

13. The method according to any of claims 9 to 12, wherein the aerogel has a dielectric constant of approximately 1.15 to 1.40, a density of approximately 0.10 g/cc (0,10 g/cm³) to 0.25 g/cc (0,25 g/cm³), and a compression strength of approximately 100 psi (0,689476 MPa) to 360 psi (2,482 MPa).

## Patentansprüche

1. Leiterplattenbaugruppe (100), die Folgendes aufweist:
eine Leiterplatte (40);
einen Flip-Chip mit monolithischer integrierter Mikrowellenschaltung (12), der an der Leiterplatte (40) angebracht ist, wobei der Flip-Chip (12) mehrere empfindliche Komponenten (14) aufweist, die der Leiterplatte (40) zugewandt sind, und wobei der Flip-Chip in einer Flip-Chip-Konfiguration von der Leiterplatte beabstandet ist;
mehrere Regionen einer dielektrischen Schicht (20) zwischen den mehreren empfindlichen Komponenten (14) und der Leiterplatte (40), wobei die Regionen der dielektrischen Schicht (20) getrennt sind und ein Aerogel aufweisen; und
eine Unterfüllung (50) zwischen dem Flip-Chip und der Leiterplatte, wobei die Unterfüllung mit der Leiterplatte und dem Flip-Chip verbunden ist, wobei die Regionen der dielektrischen Schicht verhindern, dass die Unterfüllung mit den empfindlichen Komponenten in Kontakt gelangt.

2. Leiterplattenbaugruppe nach Anspruch 1, wobei das Aerogel eine dielektrische Konstante von etwa 2,0 oder weniger aufweist.

3. Leiterplattenbaugruppe nach Anspruch 1 oder 2, wobei das Aerogel eine dielektrische Konstante von etwa 1,5 oder weniger aufweist.

4. Leiterplattenbaugruppe nach einem der Ansprüche 1 bis 3, wobei das Aerogel eine Druckfestigkeit von etwa 0,689476 MPa (100 psi) bis 2,758 MPa (400 psi) aufweist.

5. Leiterplattenbaugruppe nach einem der Ansprüche 1 bis 4, wobei das Aerogel eine Dichte von etwa 0,05 g/cm³ (0,05 g/cc) bis 0,30 g/cm³ (0,30 g/cc) aufweist.

6. Leiterplattenbaugruppe nach einem der Ansprüche 1 bis 5, wobei das Aerogel über einem Abschnitt des Flip-Chips (12) angeordnet ist, der mindestens einen Feldeffekttransistor (14) aufweist.

7. Leiterplattenbaugruppe nach einem der Ansprüche 1 bis 6, wobei das Aerogel eine dielektrische Konstante von etwa 1,15 bis 1,40, eine Dichte von etwa 0,10 g/cm³ (0,10 g/cc) bis 0,25 g/cm³ (0,25 g/cc) und eine Druckfestigkeit von etwa 0,689476 MPa (100 psi) bis 2,482 MPa (360 psi) aufweist.

8. Leiterplattenbaugruppe nach einem der Ansprüche 1 bis 7, wobei das Aerogel einen Verlustfaktor von etwa 0,002 bis 0,007 aufweist.

9. Verfahren (200) zur Herstellung mehrerer Regionen einer dielektrischen Schicht für mehrere empfindliche Komponenten (14) auf einem Flip-Chip mit monolithischer integrierter Mikrowellenschaltung (12), der einer Leiterplatte (40) zugewandt ist und in einer Flip-Chip-Konfiguration von der Leiterplatte (40) beabstandet ist, wobei das Verfahren (200) Folgendes aufweist:
Auftragen eines Aerogels über die mehreren empfindlichen Komponenten zum entsprechenden Bedecken der mehreren empfindlichen Komponenten, wobei die Regionen der dielektrischen Schicht seitlich und zwischen dem Flip-Chip (12) und der Leiterplatte (40) getrennt sind; und
Auftragen einer Unterfüllung zwischen dem Flip-Chip (12) und der Leiterplatte (40), wobei die Unterfüllung (50) mit der Leiterplatte (40) und dem Flip-Chip (12) in Kontakt steht.

10. Verfahren nach Anspruch 9, wobei das Aerogel durch Folgendes aufgetragen wird:
Ablagern (220) einer Gelbildungsvorläuferlösung auf einem Abschnitt des Flip-Chips (12);
Verarbeiten (230) der Gelbildungsvorläuferlösung zum Bilden der Regionen der dielektrischen Schicht, die das Aerogel auf dem Abschnitt des Flip-Chips (12) aufweisen; und
Anbringen (240) des Flip-Chips (12) an der Leiterplatte (40), derart, dass sich das Aerogel zwischen dem Flip-Chip (12) und der Leiterplatte (40) befindet.

11. Verfahren nach einem der Ansprüche 9 bis 10, wobei das Aerogel eine dielektrische Konstante von etwa 2,0 oder weniger und eine Druckfestigkeit von mindestens etwa 0,689476 MPa (100 psi) aufweist.

12. Verfahren nach einem der Ansprüche 9 bis 11, wobei das Aerogel eine dielektrische Konstante von etwa 1,5 oder weniger, eine Dichte von etwa 0,05 g/cm³ (0,05 g/cc) bis 0,30 g/cm³ (0,30 g/cc) und eine Druckfestigkeit von etwa 0,689476 MPa (100 psi) bis 2,758 MPa (400 psi) aufweist.

13. Verfahren nach einem der Ansprüche 9 bis 12, wobei das Aerogel eine dielektrische Konstante von etwa 1,15 bis 1,40, eine Dichte von etwa 0,10 g/cm³ (0,10 g/cc) bis 0,25 g/cm³ (0,25 g/cc) und eine Druckfestigkeit von etwa 0,689476 MPa (100 psi) bis 2,482 MPa (360 psi) aufweist.

## Revendications

1. Assemblage de carte de circuit imprimé (100) comprenant :
une carte de circuit imprimé (40) ;
une puce retournée de circuit intégré hyperfréquence monolithique (12) attachée à la carte de circuit imprimé (40), la puce retournée (12) ayant une pluralité de composants sensitifs (14) faisant face à la carte de circuit imprimé (40), laquelle puce retournée est espacée de la carte de circuit imprimé selon une configuration de puce retournée ;
une pluralité de régions de couche diélectrique (20) entre la pluralité de composants sensitifs (14) et la carte de circuit imprimé (40), lesquelles régions de couche diélectrique (20) sont séparées et comprennent un aérogel ; et
un remplissage (50) entre la puce retournée et la carte de circuit imprimé, le remplissage étant connecté à la carte de circuit imprimé et à la puce retournée, dans lequel les régions de couche diélectrique empêchent le remplissage de venir au contact des composants sensitifs.

2. Assemblage de carte de circuit imprimé selon la revendication 1, dans lequel l'aérogel a une constante diélectrique d'environ 2,0 ou moins.

3. Assemblage de carte de circuit imprimé selon la revendication 1 ou 2, dans lequel l'aérogel a une constante diélectrique d'environ 1,5 ou moins.

4. Assemblage de carte de circuit imprimé selon l'une quelconque des revendications 1 à 3, dans lequel l'aérogel a une résistance à la compression d'environ 0,689476 MPa (100 psi) à 2,758 MPa (400 psi).

5. Assemblage de carte de circuit imprimé selon l'une quelconque des revendications 1 à 4, dans lequel l'aérogel a une masse volumique d'environ 0,05 g/cc (0,05 g/cm³) à 0,30 g/cc (0,30 g/cm³).

6. Assemblage de carte de circuit imprimé selon l'une quelconque des revendications 1 à 5, dans lequel l'aérogel est disposé sur une partie de la puce retournée (12) comprenant au moins un transistor à effet de champ (14).

7. Assemblage de carte de circuit imprimé selon l'une quelconque des revendications 1 à 6, dans lequel l'aérogel a une constante diélectrique d'environ 1,15 à 1,40, une masse volumique d'environ 0,10 g/cc (0,10 g/cm³) à 0,25 g/cc (0,25 g/cm³), et une résistance à la compression d'environ 0,689476 MPa (100 psi) à 2,482 MPa (360 psi).

8. Assemblage de carte de circuit imprimé selon l'une quelconque des revendications 1 à 7, dans lequel l'aérogel a un facteur de dissipation diélectrique d'environ 0,002 à 0,007.

9. Procédé (200) pour préparer une pluralité de régions de couche diélectrique pour une pluralité de composants sensitifs (14) sur une puce retournée de circuit intégré hyperfréquence monolithique (12) faisant face à une carte de circuit imprimé (40) et espacée de la carte de circuit imprimé (40) selon une configuration de puce retournée, le procédé comprenant :
l'application d'un aérogel sur la pluralité de composants sensitifs de façon à couvrir respectivement la pluralité de composants sensitifs, les régions de couche diélectrique étant latéralement séparées et
entre la puce retournée (12) et la carte de circuit imprimé (40) ; et
l'application d'un remplissage entre la puce retournée (12) et la carte de circuit imprimé (40), le remplissage (50) venant au contact de la carte de circuit imprimé (40) et de la puce retournée (12).

10. Procédé selon la revendication 9, dans lequel l'aérogel est appliqué par :
déposition (220) d'une solution de précurseur de gélification sur une partie de la puce retournée (12) ;
traitement (230) de la solution de précurseur de gélification pour former les régions de couche diélectrique comprenant l'aérogel sur la partie de la puce retournée (12) ; et
montage (240) de la puce retournée (12) sur la carte de circuit imprimé (40) de façon que l'aérogel soit entre la puce retournée (12) et la carte de circuit imprimé (40).

11. Procédé selon l'une quelconque des revendications 9 à 10, dans lequel l'aérogel a une constante diélectrique d'environ 2,0 ou moins et une résistance à la compression d'au moins environ 0,689476 MPa (100 psi).

12. Procédé selon l'une quelconque des revendications 9 à 11, dans lequel l'aérogel a une constante diélectrique d'environ 1,5 ou moins, une masse volumique d'environ 0,05 g/cc (0,05 g/cm³) à 0,30 g/cc (0,30 g/cm³), et une résistance à la compression d'environ 0,689476 MPa (100 psi) à 2,758 MPa (400 psi).

13. Procédé selon l'une quelconque des revendications 9 à 12, dans lequel l'aérogel a une constante diélectrique d'environ 1,15 à 1,40, une masse volumique d'environ 0,10 g/cc (0,10 g/cm³) à 0,25 g/cc (0,25 g/cm³), et une résistance à la compression d'environ 0,689476 MPa (100 psi) à 2,482 MPa (360 psi).
